# EUROPEAN PATENT APPLICATION

(11) **EP 4 672 923 A2**
(43) Date of publication of application: **31.12.2025**
(21) Application number: 25213357.4
(22) Date of filing: 04.11.2025
(51) Int. Cl.: H10F 77/20

(54) **BACK CONTACT SOLAR CELL AND PHOTOVOLTAIC MODULE**

(30) Priority: 22.04.2025 CN 202510507545
(71) Applicant: JINKO SOLAR CO., LTD., Shangrao, Jiangxi 334100 (CN); Jinko Solar (Haining) Co., Ltd., Haining City, Zhejiang 314415 (CN)
(72) Inventor: WANG, Luchuang, SHANGRAO, 334100 (CN); XU, Zhaofang, SHANGRAO, 334100 (CN); TAO, Wusong, SHANGRAO, 334100 (CN); PENG, Yingying, SHANGRAO, 334100 (CN); YANG, Xubing, SHANGRAO, 334100 (CN); QIN, Niannian, SHANGRAO, 334100 (CN)
(74) Representative: Haseltine Lake Kempner LLP

(57) **Abstract**

A back contact solar cell includes a solar cell substrate, a plurality of first grid lines, a plurality of second grid lines, and a plurality of solder pads. The first grid lines and the second grid lines are disposed on the back surface and are alternately arranged. The plurality of solder pads are disposed on the back surface. The first solder pad is electrically connected to the first grid line. The second solder pad is electrically connected to the second grid line. The plurality of first solder pads includes a first test solder pad. The first test solder pad is electrically connected to at least two adjacent first grid lines. The plurality of second solder pads includes a second test solder pad. The second test solder pad is electrically connected to at least two adjacent second grid lines.

## Description

### CROSS-REFERENCE TO RELATED APPLICATIONS

The present application claims priority to Chinese patent application No. 202510507545X, entitled "BACK CONTACT SOLAR CELL AND PHOTOVOLTAIC MODULE", filed on April 22, 2025, the disclosure of which is hereby incorporated by reference in its entirety.

### TECHNICAL FIELD

The present application relates to the technical field of back contact solar cells, in particular to a back contact solar cell and a photovoltaic module.

### BACKGROUND

In the related art, after a back contact solar cell is manufactured, the back contact solar cell usually needs to be tested. Therefore, how to improve the reliability of the test of the back contact solar cell becomes a problem to be urgently solved.

### SUMMARY

According to a first aspect of the present application, there is provided a back contact solar cell, including:
a solar cell substrate having a front surface and a back surface disposed opposite to each other in a thickness direction perpendicular to the solar cell substrate;
a plurality of first grid lines and a plurality of second grid lines disposed on the back surface, wherein the first grid lines and the second grid lines are alternately arranged; and
a plurality of solder pads disposed on the back surface, and including a plurality of first solder pads and a plurality of second solder pads; wherein the plurality of first solder pads are electrically connected to the plurality of first grid lines, and the plurality of second solder pads are electrically connected to the plurality of second grid lines;
wherein the plurality of first solder pads include a first test solder pad, and the first test solder pad is electrically connected to at least two adjacent first grid lines; and
the plurality of second solder pads include a second test solder pad, and the second test solder pad is electrically connected to at least two adjacent second grid lines.

In an embodiment, the plurality of solder pads are arranged in rows and columns; the plurality of solder pads are arranged in n columns, and the first test solder pad is located in at least one column from column 2 to column n-1; the second test solder pad is located in at least one column from column 2 to column n-1, and the second test solder pad is located in a different column from the first test solder pad; where n is a positive integer, where 10≤n≤20; and/or
the plurality of solder pads are arranged in rows along a first direction, and in columns along a second direction; the plurality of solder pads are arranged in m rows; the solar cell substrate has a straight edge and a chamfer edge disposed opposite to each other along the second direction; along a direction from the chamfer edge toward the straight edge, the first test solder pad is located in one row from row 2 to row m, and the second test solder pad is located in one row from row 2 to row m; where m is a positive integer, where 2≤m≤6; and/or
the plurality of first solder pads further include a plurality of first connection solder pads; and an orthographic projection area of the first test solder pad on the solar cell substrate is larger than an orthographic projection area of the first connection solder pad on the solar cell substrate; and/or
the plurality of second solder pads further include a plurality of second connection solder pads; and an orthographic projection area of the second test solder pad on the solar cell substrate is larger than an orthographic projection area of the second connection solder pad on the solar cell substrate; and
wherein the first direction and the second direction intersect with each other, and both are perpendicular to the thickness direction of the solar cell substrate.

In an embodiment, the plurality of first grid lines and the plurality of second grid lines are disposed extending along the first direction; the plurality of first solder pads further include a plurality of first connection solder pads; and a dimension of the first test solder pad in the second direction is larger than a dimension of the first connection solder pad in the second direction; the plurality of second solder pads further include a plurality of second connection solder pads; and a dimension of the second test solder pad in the second direction is larger than a dimension of the second connection solder pad in the second direction; and wherein the first direction and the second direction intersect with each other, and both are perpendicular to the thickness direction of the solar cell substrate;
the dimension of the first test solder pad in the second direction is in a range from 2 mm to 4 mm, and the dimension of the first test solder pad in the first direction is in a range from 0.2 mm to 3 mm; and/or
the dimension of the second test solder pad in the second direction is in a range from 2 mm to 4 mm, and the dimension of the second test solder pad in the first direction is in a range from 0.2 mm to 3 mm; and/or
the plurality of first solder pads include a plurality of first connection solder pads; and a dimension of the first connection solder pad in the second direction is in a range from 0.3 mm to 3 mm, and a dimension of the first connection solder pad in the first direction is in a range from 0.2 mm to 3 mm; and/or
the plurality of second solder pads include a plurality of second connection solder pads; and a dimension of the second connection solder pad in the second direction is in a range from 0.3 mm to 3 mm, and a dimension of the second connection solder pad in the first direction is in a range from 0.2 mm to 3 mm.

In an embodiment, the back contact solar cell further includes a plurality of third grid lines and a plurality of fourth grid lines; the plurality of third grid lines and the plurality of fourth grid lines are alternately arranged on the back surface of the solar cell substrate along the first direction, and both are disposed extending along the second direction; the plurality of first grid lines and the plurality of second grid lines are disposed extending along the first direction; the plurality of third grid lines are electrically connected to the plurality of first grid lines; the plurality of fourth grid lines are electrically connected to the plurality of second grid lines; and wherein the first direction and the second direction intersect with each other, and both are perpendicular to the thickness direction of the solar cell substrate.

In an embodiment, each of the plurality of third grid lines and the plurality of fourth grid lines include a plurality of first portions connected in the second direction;
each first portion has a first end portion and a second end portion disposed opposite to each other in the second direction;
a dimension of the first end portion in the first direction is different from a dimension of the second end portion in the first direction; and
two adjacent first end portions of two adjacent first portions are connected; or two adjacent second end portions of two adjacent first portions are connected.

In an embodiment, the dimension of the first end portion in the first direction is larger than the dimension of the second end portion in the first direction;
an orthographic projection of the first end portion on a target plane overlaps with an orthographic projection of a corresponding solder pad on the target plane; an orthographic projection of the second end portion on the target plane is offset from an orthographic projection of the corresponding solder pad on the target plane; and the target plane is perpendicular to the thickness direction of the solar cell substrate; and
the dimension of the first end portion in the first direction is in a range from 0.2 mm to 1.8 mm, and the dimension of the second end portion in the first direction is in a range from 0.02 mm to 1.6 mm.

In an embodiment, the plurality of third grid lines include a first edge grid line and a plurality of first intermediate grid lines electrically connected to the first edge grid line; the plurality of fourth grid lines include a second edge grid line and a plurality of second intermediate grid lines electrically connected to the second edge grid line; and the plurality of first intermediate grid lines and the plurality of second intermediate grid lines are alternately arranged along the first direction and they are located between the first edge grid line and the second edge grid line.

The back contact solar cell further includes a plurality of fifth grid lines and a plurality of sixth grid lines disposed extending in the first direction, and the plurality of fifth grid lines and the plurality of sixth grid lines are alternately arranged.

The plurality of first grid lines and the plurality of fifth grid lines are alternately arranged along the first direction, and both are electrically connected to the first edge grid line; and the plurality of first grid lines and the plurality of sixth grid lines are alternately arranged along the second direction.

The plurality of second grid lines and the plurality of sixth grid lines are alternately arranged along the first direction, and both are electrically connected to the second edge grid line; and the plurality of second grid lines and the plurality of fifth grid lines are alternately arranged along the second direction.

The plurality of first grid lines adjacent to each other in the second direction are electrically connected to the same first intermediate grid line.

The plurality of second grid lines adjacent to each other in the second direction are electrically connected to the same second intermediate grid line.

In an embodiment, a part of the plurality of fifth grid lines each includes a first sub-grid line and a second sub-grid line arranged at intervals along the first direction; both the first sub-grid line and the second sub-grid line are electrically connected to the first grid lines; the second intermediate grid line is located between the first sub-grid line and the second sub-grid line of the fifth grid line adjacent to each other in the first direction to be electrically isolated from such fifth grid line; and the second solder pad is located between the first sub-grid line and the second sub-grid line of the fifth grid line adjacent to each other in the first direction to be electrically isolated from such fifth grid line.

A part of the plurality of sixth grid lines each includes a third sub-grid line and a fourth sub-grid line arranged at intervals along the first direction; both the third sub-grid line and the fourth sub-grid line are electrically connected to the second grid lines; the first intermediate grid line is located between the third sub-grid line and the fourth sub-grid line of the sixth grid line adjacent to each other in the first direction to be electrically isolated from such sixth grid line; and the first solder pad is located between the third sub-grid line and the fourth sub-grid line of the sixth grid line adjacent to each other in the first direction to be electrically isolated from such sixth grid line.

In an embodiment, the back contact solar cell further includes a plurality of seventh grid lines and a plurality of eighth grid lines; the plurality of solder pads further include a plurality of third solder pads and a plurality of fourth solder pads; the plurality of first solder pads and the plurality of second solder pads are located between the plurality of third solder pads and the plurality of fourth solder pads along the first direction; the plurality of third solder pads and the first edge grid line are spaced apart in the first direction and disposed on a side of the solar cell substrate along the first direction, and the plurality of third solder pads are electrically connected to the first edge grid line through the plurality of seventh grid lines; and the plurality of fourth solder pads and the second edge grid line are spaced apart in the first direction and disposed on another side of the solar cell substrate along the first direction, and the plurality of fourth solder pads are electrically connected to the second edge grid line through the plurality of eighth grid lines.

In an embodiment, the back contact solar cell further includes a plurality of ninth grid lines; the plurality of fifth grid lines are arranged in rows and columns, in a column of fifth grid lines that is closest to the second edge grid line in the first direction, a fifth grid line including the first sub-grid line and the second sub-grid line is defined as a first target grid line, the first sub-grid line of the first target grid line is electrically connected to the first grid line, the second sub-grid line of the first target grid line is electrically connected to the first grid line through an adjacent ninth grid line and an adjacent fifth grid line; and the fourth solder pad is disposed between the first sub-grid line and the second sub-grid line of the first target grid line adjacent to each other in the first direction; and/or
the back contact solar cell further includes a plurality of tenth grid lines; the plurality of sixth grid lines are arranged in rows and columns, in a column of sixth grid lines that is closest to the first edge grid line in the first direction, a sixth grid line including the third sub-grid line and the fourth sub-grid line is defined as a second target grid line; the third sub-grid line of the second target grid line is electrically connected to the second grid line, the fourth sub-grid line of the second target grid line is electrically connected to the second grid line through an adjacent tenth grid line and an adjacent sixth grid line; and the third solder pad is disposed between the third sub-grid line and the fourth sub-grid line of the second target grid line adjacent to each other in the first direction.

In an embodiment, the back contact solar cell further includes at least two positioning marks disposed on the solar cell substrate;
the plurality of first grid lines and the plurality of second grid lines are arranged on the solar cell substrate at preset positions with reference to the at least two positioning marks;
the at least two positioning marks are symmetrically distributed relative to a first preset plane;
a spacing between centers of two adjacent positioning marks in the first direction is a first preset spacing;
in two back contact solar cells symmetrically arranged relative to a second preset plane, a spacing between centers of two adjacent positioning marks in the second direction is a second preset spacing;
the first preset plane is perpendicular to the first direction, the second preset plane is perpendicular to the second direction, and the first direction and the second direction intersect with each other and both are perpendicular to the thickness direction of the solar cell substrate;
the first preset spacing is in a range from 110 mm to 130 mm; and
the second preset spacing is in a range from 110 mm to 130 mm.

In an embodiment, the at least two positioning marks include at least two first positioning marks and at least two second positioning marks;
the preset positions include a plurality of first preset positions corresponding to the plurality of first grid lines, and a plurality of second preset positions corresponding to the plurality of second grid lines; the plurality of first grid lines are arranged on the solar cell substrate at the first preset positions with reference to the at least two first positioning marks; and the plurality of second grid lines are arranged on the solar cell substrate at the second preset positions with reference to the at least two second positioning marks; and/or
an orthographic projection of the positioning mark on the solar cell substrate is configured as a circle having a diameter in a range from 0.01 mm to 2 mm; and/or
the plurality of first grid lines are arranged in rows and columns; each of the plurality of first grid lines has a first symmetry axis parallel to the first direction; and an orthographic projection of a center of the first positioning mark on the solar cell substrate coincides with an orthographic projection of the first symmetry axis of the first grid line in a corresponding row on the solar cell substrate; and/or
the plurality of second grid lines are arranged in rows and columns; each of the plurality of second grid lines has a second symmetry axis parallel to the first direction; and an orthographic projection of a center of the second positioning mark on the solar cell substrate coincides with an orthographic projection of the second symmetry axis of the second grid line in a corresponding row on the solar cell substrate.

According to a second aspect of the present application, there is provided a photovoltaic module including a solar cell string, wherein the solar cell string includes a plurality of back contact solar cells according to any of the above embodiments.

In the technical solutions of the present application, a positive electrode and a negative electrode of a test device can be respectively connected to the first test solder pad and the second test solder pad. Since the first test solder pad is electrically connected to at least two first grid lines and the second test solder pad is electrically connected to at least two second grid lines, when the test device is used to test the back contact solar cell, the reliability of the electrical connection between the first test solder pad and the solar cell substrate can be improved, and the reliability of the electrical connection between the second test solder pad and the solar cell substrate can also be improved, so that the reliability of the test of the back contact solar cell can be improved.

### BRIEF DESCRIPTION OF THE DRAWINGS

FIG. 1 shows a schematic structural diagram of a back contact solar cell provided with an insulating layer according to an embodiment of the present application.
FIG. 2 shows a schematic structural diagram of a back contact solar cell without an insulating layer according to an embodiment of the present application.
FIG. 3 shows a schematic structural diagram of two first portions according to an embodiment of the present application.
FIG. 4 shows a schematic structural diagram of two first portions according to another embodiment of the present application.
FIG. 5 shows a schematic structural diagram of two first portions according to still another embodiment of the present application.
FIG. 6 shows an enlarged schematic view at A1 of FIG. 1.
FIG. 7 shows an enlarged schematic view at A2 of FIG. 1.
FIG. 8 shows an enlarged schematic view at A3 of FIG. 1.
FIG. 9 shows an enlarged schematic view at A4 of FIG. 1.
FIG. 10 shows an enlarged schematic view at A5 of FIG. 1.
FIG. 11 shows a schematic structural diagram of two back contact solar cells according to an embodiment of the present application.

Reference Numerals: 10, back contact solar cell; 100, solar cell substrate; 101, first edge; 102, second edge; 103, straight edge; 104, chamfer edge; 210, first grid line; 220, second grid line; 230, third grid line; 240, fourth grid line; 231, first edge grid line; 232, first intermediate grid line; 233, first portion; 2331, first end portion; 2332, second end portion; 241, second edge grid line; 242, second intermediate grid line; 250, fifth grid line; 251, first sub-grid line; 252, second sub-grid line; 260, sixth grid line; 261, third sub-grid line; 262, fourth sub-grid line; 270, seventh grid line; 280, eighth grid line; 291, ninth grid line; 292, tenth grid line; 293, eleventh grid line; 294, twelfth grid line; 310, first solder pad; 311, first test solder pad; 312, first connection solder pad; 320, second solder pad; 321, second test solder pad; 322, second connection solder pad; 330, third solder pad; 340, fourth solder pad; 400, positioning mark; 410, first positioning mark; 420, second positioning mark; P1, first preset plane; P2, second preset plane; 510, first insulating portion; 520, second insulating portion; 530, third insulating portion; and 540, fourth insulating portion.

### DETAILED DESCRIPTION

In order to make the objectives, features, and advantages of the present application more apparent and understandable, the specific implementations of the present application will be explained in detail below in conjunction with the accompanying drawings. In the following description, numerous specific details are set forth in order to facilitate a thorough understanding of the present application. However, the present application can be implemented in many other ways different from those described herein, and those skilled in the art can make similar modifications without departing from the spirit of the application, so that the present application is not limited to the specific embodiments disclosed below.

In the description of the present application, it is to be understood that if the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. appear, they indicate the orientations or positional relationships on the basis of the drawings. These terms are only intended for facilitating illustrating the present application and simplifying the illustration, rather than indicating or implying that the devices or elements referred thereto have to present particular orientations, and be constructed and operated in particular orientations, and therefore cannot be construed as limiting the present disclosure.

In addition, if the terms "first" and "second" appear, they are only intended for illustrative purposes, rather than being construed as indicating or implying relative importance or implicitly designating the number of the technical features as indicated. Thus, the features modified by "first" and "second" may explicitly or implicitly include at least one said feature. In the description of the present application, if the term "a plurality of" appear, it means at least two, for example two or three, unless otherwise explicitly and specifically defined.

In the present application, unless otherwise expressly specified and defined, if the terms "mounted", "connected to", "coupled" and "fixed" appear, they should be understood in a broad sense, for example, fixedly connected or detachably connected, or integrated; mechanically connected or electrically connected; directly connected or indirectly connected through an intermediate medium, or in an interior communication or mutual interaction relationship between two elements, unless otherwise specifically defined. For those of ordinary skill in the art, the specific meanings of the above-described terms in the present application may be understood according to specific circumstances.

In the present application, unless otherwise expressly stated and defined, the first feature, if being referred to as being located "above" or "below" the second feature, may be in direct contact with the second feature, or in indirect contact with the second feature via an intermediate feature. Moreover, the first feature, when being referred to as being disposed "on", "above" and "over" the second feature, may be disposed right above or obliquely above the second feature, or simply disposed at a level higher than the second feature. The first feature, when being referred to as being disposed "under", "below" and "beneath" the second feature, may be disposed directly below or obliquely below the second feature, or simply disposed at a level lower than the second feature.

It should be noted that, if an element is referred to as being "fixed to" or "disposed on" another element, it may be directly on the other element or may also be present with an intermediate element. If an element is referred to as being "connected" to another element, it may be directly connected to the other element or may be present with an intermediate element at the same time. If the terms "vertical", "horizontal", "up", "down", "left", "right" and similar expressions are used herein, they are only for the purpose of illustration, rather than presenting the only ways for implementation.

It should be noted that, in the present application, when "electrical connection", "electrically connected to", or "in an electrical contact with" are mentioned, it means that, a person skilled in the art appreciates that, since the connecting material is a conductive material, there is an electrical connection between a first structure and a second structure when a device (i.e., a back contact solar cell herein) is in the state of generating power or supplying power.

It should be noted that, in the present application, when referring to "solar cell substrate", it refers to a silicon wafer substrate that has been doped and is formed with a p-n junction, which absorbs photons on the front side to generate charge carriers, and forms an alternating P-type and N-type contact structure on the back side; but it has not been metallized (i.e., grid lines and pads are not fabricated).

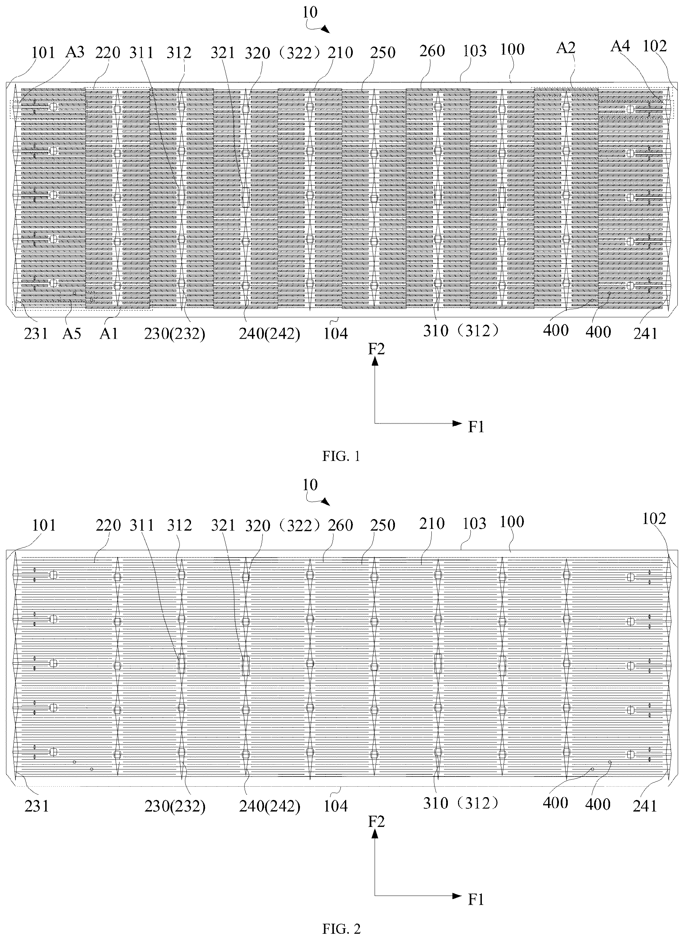

FIG. 1 shows a schematic structural diagram of a back contact solar cell 10 provided with an insulating layer according to an embodiment of the present application. FIG. 2 shows a schematic structural diagram of a back contact solar cell 10 without an insulating layer according to an embodiment of the present application.

Referring to FIG. 1 and FIG. 2, an embodiment of the present application provides a back contact solar cell 10 including a solar cell substrate 100, a plurality of first grid lines 210, a plurality of second grid lines 220 and a plurality of solder pads.

The solar cell substrate 100 has a front surface and a back surface disposed opposite to each other in a thickness direction perpendicular to the solar cell substrate 100. The plurality of first grid lines 210 and the plurality of second grid lines 220 are disposed on the back surface, and the first grid line 210 and the second grid line 220 are alternately arranged.

Optionally, the plurality of first grid lines 210 and the plurality of second grid lines 220 are arranged in rows along a first direction F1 and in columns along a second direction F2. The first direction F1 and the second direction F2 intersect with each other, and are perpendicular to the thickness direction of the solar cell substrate 100. The first grid lines 210 and the second grid lines 220 are alternately arranged along the first direction F1 and alternately arranged along the second direction F2.

Specifically, the first direction F1 and the second direction F2 are perpendicular to each other, and both are perpendicular to the thickness direction of the solar cell substrate 100. One of the first direction F1 and the second direction F2 is a length direction of the solar cell substrate 100, and the other of the first direction F1 and the second direction F2 is a width direction of the solar cell substrate 100. For example, the first direction F1 is the length direction of the solar cell substrate 100, and the second direction F2 is the width direction of the solar cell substrate 100.

Both the first grid line 210 and the second grid line 220 are fingers. The back contact solar cell 10 of the present application can be a back contact solar cell 10 without a busbar or a back contact solar cell 10 with a busbar, which is not particularly limited herein.

A plurality of solder pads are disposed on the back surface, and the plurality of solder pads include a plurality of first solder pads 310 and a plurality of second solder pads 320. The first solder pad 310 is electrically connected to the first grid line 210, and the second solder pad 320 is electrically connected to the second grid line 220. The plurality of first solder pads 310 include a first test solder pad 311. The first test solder pad 311 is electrically connected to at least two adjacent first grid lines 210. The plurality of second solder pads 320 include a second test solder pad 321. The second test solder pad 321 is electrically connected to at least two adjacent second grid lines 220.

Specifically, an orthographic projection of the first test solder pad 311 on the solar cell substrate 100 overlaps with an orthographic projection of the at least two adjacent first grid lines 210 on the solar cell substrate 100, and an orthographic projection of the second test solder pad 321 on the solar cell substrate 100 overlaps with an orthographic projection of the at least two adjacent second grid lines 220 on the solar cell substrate 100.

A test device can be used to test the back contact solar cell 10 of the present application. A positive electrode and a negative electrode of the test device can be respectively connected to the first test solder pad 311 and the second test solder pad 321. Since the first test solder pad 311 is electrically connected to at least two first grid lines 210 and the second test solder pad 321 is electrically connected to at least two second grid lines 220, when the test device is used to test the back contact solar cell 10, the reliability of the electrical connection between the first test solder pad 311 and the solar cell substrate 100 can be improved, and the reliability of the electrical connection between the second test solder pad 321 and the solar cell substrate 100 can also be improved, so that the reliability of the test of the back contact solar cell 10 can be improved.

In some embodiments, the plurality of solder pads are arranged in rows and columns, and the solder pads are arranged in n columns. The first test solder pad 311 is located in at least one column from column 2 to column n-1. The second test solder pad 321 is located in at least one column from column 2 to column n-1 and is in a different column from the first test solder pad 311. n is a positive integer, and 10≤n≤20. Specifically, n can be an even number. For example, n can be 10, 12, 14, 16, 18, 20, etc.

Exemplarily, n is 10. Both the first grid line 210 and the second grid line 220 are disposed extending along a first direction F1. The solar cell substrate 100 has a first edge 101 and a second edge 102 opposite to each other along the first direction F1. Two first test solder pads 311 are provided on the solar cell substrate 100. One of the two first test solder pads 311 is closer to the first edge 101 than the second edge 102 along the first direction F1, and such first test solder pad 311 is located in column 3 along a direction from the first edge 101 toward the second edge 102. Another one of the two first test solder pads 311 is closer to the second edge 102 than the first edge 101 along the first direction F1, and such first test solder pad 311 is located in column 4 along a direction from the second edge 102 toward the first edge 101.

Thus, the two first test solder pads 311 are both located in intermediate columns, so that the current of all the first grid lines 210 can be better collected by the two first test solder pads 311, thereby improving the reliability of the test of the back contact solar cell 10.

Exemplarily, n is 10. The solar cell substrate 100 has the first edge 101 and the second edge 102 opposite to each other along the first direction F1. Two second test solder pads 321 are provided on the solar cell substrate 100. One of the two second test solder pads 321 is closer to the second edge 102 than the first edge 101 along the first direction F1, and such second test solder pad 321 is located in column 3 along the direction from the second edge 102 toward the first edge 101. Another one of the two second test solder pads 321 is closer to the first edge 101 than the second edge 102 along the first direction F1, and such second test solder pad 321 is located in column 4 along the direction from the first edge 101 toward the second edge 102.

Thus, the two second test solder pads 321 are both located in intermediate columns, so that the current of all the second grid lines 220 can be better collected by the two second test solder pads 321, thereby improving the reliability of the test of the back contact solar cell 10.

In some embodiments, the plurality of solder pads are arranged in rows along the first direction F1 and in columns along the second direction F2, and the solder pads are arranged in m rows. The solar cell substrate 100 has a straight edge 103 and a chamfer edge 104 disposed opposite to each other along the second direction F2. The first direction F1 and the second direction F2 are perpendicular to each other, and both are perpendicular to the thickness direction of the solar cell substrate 100. The first test solder pad 311 is located in one row from row 2 to row m, and the second test solder pad 321 is located in one row from row 2 to row m, wherein m is a positive integer, and 2≤m≤6. Specifically, m can be 2, 3, 4, 5, 6, etc.

Specifically, the first test solder pad 311 and the second test solder pad 321 are both located in the same row.

Exemplarily, m is 5, and the first test solder pad 311 is located in row 3 and the second test solder pad 321 is located in row 3 along a direction from the chamfer edge 104 toward the straight edge 103.

Thus, the first test solder pad 311 is located in an intermediate row, so that the current of the plurality of first grid lines 210 can be better collected by the first test solder pad 311, thereby improving the reliability of the test of the back contact solar cell 10.

Similarly, the second test solder pad 321 is located in an intermediate row, so that the current of the plurality of second grid lines 220 can be better collected by the second test solder pad 321, thereby improving the reliability of the test of the back contact solar cell 10.

In some embodiments, the plurality of first solder pads 310 further includes a plurality of first connection solder pads 312. The orthographic projection area of the first test solder pad 311 on the solar cell substrate 100 is larger than the orthographic projection area of the first connection solder pad 312 on the solar cell substrate 100.

In this way, the first test solder pad 311 is facilitated to be electrically connected to more first grid lines 210, so that the reliability of the test of the back contact solar cell 10 can be improved.

In some embodiments, the plurality of second solder pads 320 further includes a plurality of second connection solder pads 322. The orthographic projection area of the second test solder pad 321 on the solar cell substrate 100 is larger than the orthographic projection area of the second connection solder pad 322 on the solar cell substrate 100.

In this way, the second test solder pad 321 is facilitated to be electrically connected to more second grid lines 220, so that the reliability of the test of the back contact solar cell 10 can be improved.

In some embodiments, both the first grid line 210 and the second grid line 220 are disposed extending along the first direction F1. The plurality of first solder pads 310 further includes a plurality of first connection solder pads 312. The dimension of the first test solder pad 311 in the second direction F2 is larger than the dimension of the first connection solder pad 312 in the second direction F2. The plurality of second solder pads 320 further include a plurality of second connection solder pads 322. The dimension of the second test solder pad 321 in the second direction F2 is larger than the dimension of the second connection solder pad 322 in the second direction F2. The first direction F1 and the second direction F2 intersect with each other, and both are perpendicular to the thickness direction of the solar cell substrate 100.

By configuring the dimension of the first test solder pad 311 in the second direction F2 to be larger than the dimension of the first connection solder pad 312 in the second direction F2, in combination that the first grid line 210 is disposed extending along the first direction F1 which intersects with the second direction F2, the first test solder pad 311 is facilitated to be electrically connected to more first grid lines 210, so that the reliability of the test of the back contact solar cell 10 can be improved.

By configuring the dimension of the second test solder pad 321 in the second direction F2 to be larger than the dimension of the second connection solder pad 322 in the second direction F2, in combination that the second grid line 220 is disposed extending along the first direction F1 which intersects with the second direction F2, the second test solder pad 321 is facilitated to be electrically connected to more second grid lines 220, so that the reliability of the test of the back contact solar cell 10 can be improved.

In some embodiments, the dimension of the first test solder pad 311 in the second direction F2 is in a range from 2 mm to 4 mm, and the dimension of the first test solder pad 311 in the first direction F1 is in a range from 0.2 mm to 3 mm.

Exemplarily, the dimension of the first test solder pad 311 in the second direction F2 is 2 mm, 3 mm, or 4 mm, and the dimension of the first test solder pad 311 in the first direction F1 is 0.2 mm, 0.5 mm, 1.0 mm, 2.0 mm, or 3 mm.

Since the dimension of the first test solder pad 311 in the second direction F2 is in an appropriate range, for example, from 2 mm to 4 mm, and the dimension of the first test solder pad 311 in the first direction F1 is in an appropriate range, for example, from 0.2 mm to 3 mm, the first test solder pad 311 is facilitated to be electrically connected to more first grid lines 210, and the first test solder pad 311 can form sufficient surface contact with adjacent first grid lines 210, so that the reliability of the test of the back contact solar cell 10 can be improved.

The dimension of the second test solder pad 321 in the second direction F2 is in a range from 2 mm to 4 mm, and the dimension of the second test solder pad 321 in the first direction F1 is in a range from 0.2 mm to 3 mm.

Exemplarily, the dimension of the second test solder pad 321 in the second direction F2 is 2 mm, 3 mm, or 4 mm, and the dimension of the second test solder pad 321 in the first direction F1 is 0.2 mm, 0.5 mm, 1.0 mm, 2.0 mm, or 3 mm.

Since the dimension of the second test solder pad 321 in the second direction F2 is in an appropriate range, for example, from 2 mm to 4 mm, and the dimension of the second test solder pad 321 in the first direction F1 is in an appropriate range, for example, from 0.2 mm to 3 mm, the second test solder pad 321 is facilitated to be electrically connected to more second grid lines 220, and the second test solder pad 321 can form sufficient surface contact with adjacent second grid lines 220, so that the reliability of the test of the back contact solar cell 10 can be improved.

In some embodiments, the plurality of first solder pads 310 includes a plurality of first connection solder pads 312. The dimension of the first connection solder pad 312 in the second direction F2 is in a range from 0.3 mm to 3 mm, and the dimension of the first connection solder pad 312 in the first direction F1 is in a range from 0.2 mm to 3 mm.

Exemplarily, the dimension of the first connection solder pad 312 in the second direction F2 is 0.3 mm, 1 mm, 2 mm, or 3 mm, and the dimension of the first connection solder pad 312 in the first direction F1 is 0.2 mm, 1 mm, 2 mm, or 3 mm.

In this way, the first connection solder pad 312 has a sufficient area, which facilitates improving the reliability of the connection between the first connection solder pad 312 and the first grid line 210, improving the reliability of the connection between the first connection solder pad 312 and a third grid line 230 described below, and improving the reliability of the connection between the first connection solder pad 312 and a corresponding first solder strip (not shown in the figures).

The plurality of second solder pads 320 includes a plurality of second connection solder pads 322. The dimension of the second connection solder pad 322 in the second direction F2 is in a range from 0.3 mm to 3 mm, and the dimension of the second connection solder pad 322 in the first direction F1 is in a range from 0.2 mm to 3 mm.

Exemplarily, the dimension of the second connection solder pad 322 in the second direction F2 is 0.3 mm, 1 mm, 2 mm, or 3 mm, and the dimension of the second connection solder pad 322 in the first direction F1 is 0.2 mm, 1 mm, 2 mm, or 3 mm.

In this way, the second connection solder pad 322 has a sufficient area, which facilitates improving the reliability of the connection between the second connection solder pad 322 and the second grid line 220, improving the reliability of the connection between the second connection solder pad 322 and a fourth grid line 240 described below, and improving the reliability of the connection between the second connection solder pad 322 and a corresponding second solder strip (not shown in the figures).

In some embodiments, the back contact solar cell 10 further includes a plurality of third grid lines 230 and a plurality of fourth grid lines 240. The third grid lines 230 and the fourth grid lines 240 are alternately arranged on the back surface of the solar cell substrate 100 along the first direction F1, and both are disposed extending along the second direction F2. Both the first grid line 210 and the second grid line 220 are disposed extending along the first direction F1. The third grid line 230 is electrically connected to the first grid line 210. The fourth grid line 240 is electrically connected to the second grid line 220. The first direction F1 and the second direction F2 intersect with each other, and both are perpendicular to the thickness direction of the solar cell substrate 100.

Specifically, both the third grid line 230 and the fourth grid line 240 are main grids.

The plurality of first grid lines 210 and the plurality of second grid lines 220 can be used to collect carriers of two different polarities of the solar cell substrate 100. The plurality of third grid lines 230 can be used to collect the carriers collected by all the first grid lines 210. The plurality of fourth grid lines 240 can be used to collect the carriers collected by all the second grid lines 220. This facilitates the output of the collected current through the plurality of third grid lines 230 and the plurality of fourth grid lines 240, so that the collecting ability of the back contact solar cell 10 to the carriers can be improved, and the current collecting efficiency of the back contact solar cell 10 can be improved.

In some embodiments, the third grid line 230 and the fourth grid line 240 both include a plurality of first portions 233 connected in the second direction F2. Each first portion 233 has a first end portion 2331 and a second end portion 2332 disposed opposite to each other in the second direction F2. The dimension of the first end portion 2331 in the first direction F1 is different from the dimension of the second end portion 2332 in the first direction F1.

In some embodiments, two adjacent first end portions 2331 of two adjacent first portions 233 can be connected. Alternatively, two adjacent second end portions 2332 of two adjacent first portions 233 can be connected.

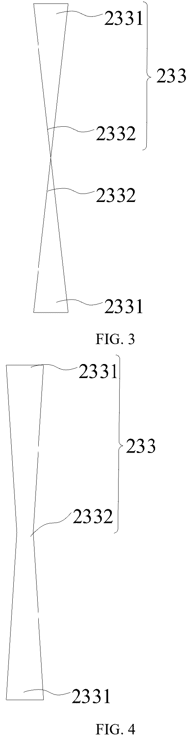

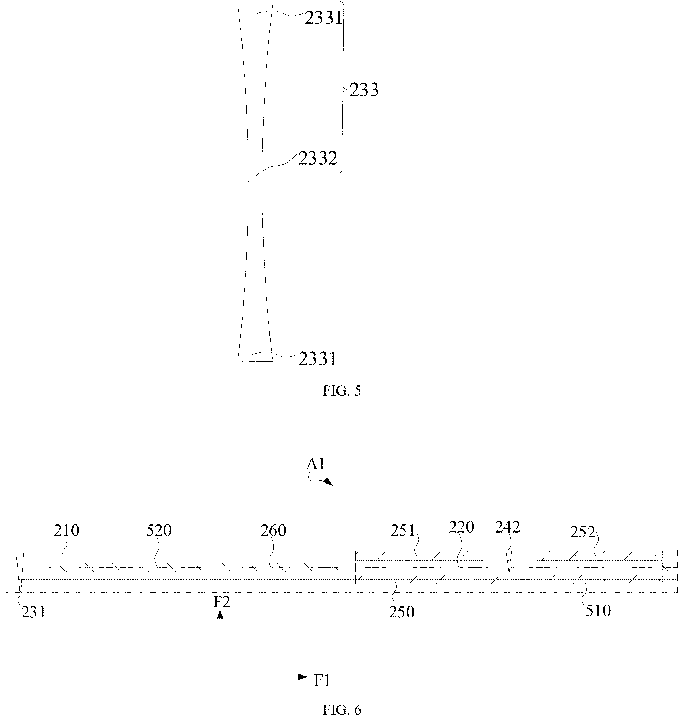

In some embodiments, as shown in FIG. 3 and FIG. 4, the orthographic projections of the first portions 233 of the third grid line 230 and the fourth grid line 240 on the solar cell substrate 100 have a shape of an isosceles triangle or an isosceles trapezoid, etc. Alternatively, as shown in FIG. 5, the second end portions 2332 of two first portions 233 are connected, and the orthographic projection of the two first portions 233 on the solar cell substrate 100 has a slender hourglass shape (i.e., centrally concave).

Along the second direction F2, dimensions of the third grid line 230 and the fourth grid line 240 in the first direction F1 tend to change. In a case where the plurality of third grid lines 230 are used to collect the carriers collected by all the first grid lines 210, and the plurality of fourth grid lines 240 are used to collect the carriers collected by all the second grid lines 220, reducing the occupied areas of the third grid lines 230 and the fourth grid lines 240 can further reduce the manufacturing costs of all the third grid lines 230 and all the fourth grid lines 240, due to relatively expensive grid line material (usually being silver). By configuring the third grid line 230 and the fourth grid line 240 designed with varied dimensions, the manufacturing costs of the third grid line 230 and the fourth grid line 240 can be reduced. In some embodiments, the dimension of the first end portion 2331 in the first direction F1 is larger than the dimension of the second end portion 2332 in the first direction F1. The orthographic projection of the first end portion 2331 on a target plane overlaps with the orthographic projection of a corresponding solder pad on the target plane. The orthographic projection of the second end portion 2332 on the target plane is offset from the orthographic projection of the corresponding solder pad on the target plane. The target plane is perpendicular to the thickness direction of the solar cell substrate 100.

In some cases, the orthographic projection of a first end portion 2331 on the target plane overlaps with the orthographic projection of an adjacent first solder pad 310 on the target plane, and the orthographic projection of a second end portion 2332 connected to such first end portion 2331, on the target plane is offset from the orthographic projection of such first solder pad 310 on the target plane.

In other cases, the orthographic projection of a first end portion 2331 on the target plane overlaps with the orthographic projection of an adjacent second solder pad 320 on the target plane, and the orthographic projection of a second end portion 2332 connected to such first end portion 2331, on the target plane is offset from the orthographic projection of such second solder pad 320 on the target plane.

In this way, the first solder pad 310 can be connected to the first end portion 2331 of the corresponding third grid line 230, that is, the first solder pad 310 can be connected to a relatively wide position on the corresponding third grid line 230; and the second solder pad 320 can be connected to the first end portion 2331 of the corresponding fourth grid line 240, that is, the second solder pad 320 can be connected to a relatively wide position on the corresponding fourth grid line 240. Therefore, the reliability of the connection between the first solder pad 310 and the corresponding third grid line 230 can be improved, the reliability of the connection between the second solder pad 320 and the corresponding fourth grid line 240 can also be improved, so that the current can be collected better by the first solder strip configured to be electrically connected to the first solder pads 310, and the current can be collected better by the second solder strip configured to be electrically connected to the second solder pads 320.

In some embodiments, the dimension of the first end portion 2331 in the first direction F1 is in a range from 0.2 mm to 1.8 mm, and the dimension of the second end portion 2332 in the first direction F1 is in a range from 0.02 mm to 1.6 mm.

For example, the dimension of the first end portion 2331 in the first direction F1 is 0.2 mm, and the dimension of the second end portion 2332 in the first direction F1 is 0.02 mm. For another example, the dimension of the first end portion 2331 in the first direction F1 is 1.2 mm, and the dimension of the second end portion 2332 in the first direction F1 is 1.0 mm. For still another example, the dimension of the first end portion 2331 in the first direction F1 is 1.8 mm, and the dimension of the second end portion 2332 in the first direction F1 is 1.6 mm.

Since the dimension of the first end portion 2331 in the first direction F1 is in an appropriate range, for example, from 0.2 mm to 1.8 mm, and the dimension of the second end portion 2332 in the first direction F1 is in an appropriate range, for example, from 0.02 mm to 1.6 mm, the third grid line 230 and the fourth grid line 240 can be used to collect current, while considering and balancing the electrical resistance and manufacturing cost of the third grid line 230 and the fourth grid line 240.

In some embodiments, the plurality of third grid lines 230 include a first edge grid line 231 and a plurality of first intermediate grid lines 232 electrically connected to the first edge grid line 231, and the plurality of fourth grid lines 240 include a second edge grid line 241 and a plurality of second intermediate grid lines 242 electrically connected to the second edge grid line 241. The first intermediate grid lines 241 and the second intermediate grid lines 242 are alternately arranged along the first direction F1, and are located between the first edge grid line 231 and the second edge grid line 232. The first edge grid line 231 and the second intermediate grid line 242 are disposed adjacent to each other in the first direction F1, and the second edge grid line 241 and the first intermediate grid line 232 are disposed adjacent to each other in the first direction F1. The back contact solar cell 10 further includes a plurality of fifth grid lines 250 and a plurality of sixth grid lines 260 extending in the first direction F1, and the fifth grid lines 250 and the sixth grid lines 260 are alternately arranged. The first grid lines 210 and the fifth grid lines 250 are alternately arranged along the first direction F1, and both are electrically connected to the first edge grid line 231. The first grid lines 210 and the sixth grid lines 260 are alternately arranged along the second direction F2. The second grid lines 220 and the sixth grid lines 260 are alternately arranged along the first direction F1, and both are electrically connected to the second edge grid line 241. The second grid lines 220 and the fifth grid lines 250 are alternately arranged along the second direction F2. A plurality of first grid lines 210 adjacent to each other in the second direction F2 are electrically connected to the same first intermediate grid line 232. A plurality of second grid lines 220 adjacent to each other in the second direction F2 are electrically connected to the same second intermediate grid line 242.

Optionally, the first grid lines 210 and the fifth grid lines 250 are alternately connected along the first direction F1 to facilitate synchronously forming the plurality of first grid lines 210 and the plurality of fifth grid lines 250.

Optionally, the second grid lines 220 and the sixth grid lines 260 are alternately connected along the first direction F1 to facilitate synchronously forming the plurality of second grid lines 220 and the plurality of sixth grid lines 260.

Specifically, all the first grid lines 210, all the second grid lines 220, all the fifth grid lines 250, and all the sixth grid lines 260 are arranged in rows along the first direction F1 and in columns along the second direction F2, respectively.

A plurality of columns of first grid lines 210 and a plurality of columns of second grid lines 220 are alternately arranged along the first direction F1, and one column of the first grid lines 210 and one adjacent column of the second grid lines 220 are arranged in a staggered manner along the second direction F2. A plurality of columns of fifth grid lines 250 and a plurality of columns of sixth grid lines 260 are alternately arranged along the first direction F1, and one column of the fifth grid lines 250 and one adjacent column of the sixth grid lines 260 are arranged in a staggered manner along the second direction F2. The first grid lines 210 and the fifth grid lines 250 alternately arranged along the first direction F1 are located in the same row, and the second grid lines 220 and the sixth grid lines 260 alternately arranged along the first direction F1 are located in the same row.

Optionally, the first grid line 210 has a first symmetry axis parallel to the first direction F1, the fifth grid line 250 has a third symmetry axis parallel to the first direction F1, and the first symmetry axis of the first grid line 210 and the third symmetry axis of the fifth grid line 250 in the same row coincide with each other.

Optionally, the dimension of the first grid line 210 and the dimension of the fifth grid line 250 in the second direction F2 are equal.

Optionally, the second grid line 220 has a second symmetry axis parallel to the first direction F1, the sixth grid line 260 has a fourth symmetry axis parallel to the first direction F1, and the second symmetry axis of the second grid line 220 and the fourth symmetry axis of the sixth grid line 260 in the same row coincide with each other.

Optionally, the dimension of the second grid line 220 and the dimension of the sixth grid line 260 in the second direction F2 are equal.

Optionally, the dimension of the first grid line 210 and the dimension of the second grid line 220 in the second direction F2 are equal.

Since both the first grid line 210 and the fifth grid line 250 are electrically connected to the first edge grid line 231, and both the second grid line 220 and the sixth grid line 260 are electrically connected to the second edge grid line 241, carriers collected by the plurality of first grid lines 210 and the plurality of fifth grid lines 250 can be collected to the first edge grid line 231, and carriers collected by the plurality of second grid lines 220 and the plurality of sixth grid lines 260 can be collected to the second edge grid line 241, so as to facilitate outputting current through the first edge grid line 231 and the second edge grid line 241.

The plurality of first grid lines 210 adjacent to each other in the second direction F2 are electrically connected to the same first intermediate grid line 232, and the plurality of second grid lines 220 adjacent to each other in the second direction F2 are electrically connected to the same second intermediate grid line 242. Specifically, the plurality of first grid lines 210 of the same column are electrically connected to the same first intermediate grid line 232, and the plurality of second grid lines 220 of the same column are electrically connected to the same second intermediate grid line 242. Since the plurality of first grid lines 210 in the same column are collected by the first intermediate grid line 232, and the first grid lines 210 and the fifth grid lines 250 in the same row are connected to the first edge grid line 231, carriers collected by all first grid lines 210 and all fifth grid lines 250 can be collected to the first edge grid line 231. Similarly, carriers collected by all second grid lines 220 and all sixth grid lines 260 can be collected to the second edge grid line 241. Therefore, outputting current through the first edge grid line 231 and the second edge grid line 241 can be facilitated.

In some embodiments, referring to FIG. 1 and FIG. 6, some fifth grid lines 250 include a first sub-grid line 251 and a second sub-grid line 252 arranged at intervals along the first direction F1. Both the first sub-grid line 251 and the second sub-grid line 252 are electrically connected to the first grid lines 210. The second intermediate grid line 242 is located between the first sub-grid line 251 and the second sub-grid line 252 of the fifth grid line 250 adjacent to each other in the first direction F1 to be electrically isolated from such fifth grid line 250. The second solder pad 320 is located between the first sub-grid line 251 and the second sub-grid line 252 of the fifth grid line 250 adjacent to each other in the first direction F1 to be electrically isolated from such fifth grid line 250.

Specifically, the second intermediate grid line 242 is located between the first sub-grid lines 251 and the second sub-grid lines 252 of the fifth grid lines 250 in the same column in the first direction F1 to be electrically isolated from these fifth grid lines 250.

In this way, the second intermediate grid line 242 can be electrically isolated from the fifth grid lines 250 in the same column, and the second intermediate grid line 242 can be electrically connected to the second grid lines 220 in the same column, so that the carriers collected by the plurality of second grid lines 220 in the same column can be collected by the second intermediate grid line 242, an avoidance design between the second intermediate grid line 242 as a busbar and the fifth grid lines 250 as fingers with opposite polarity can be realized, and an avoidance design between the fifth grid lines 250 and the second solder pads 320 with opposite polarity can be realized.

It should be noted that at least one fifth grid line 250 in each column of fifth grid lines 250 does not include the first sub-grid line 251 and the second sub-grid line 252. For example, in the fifth grid lines 250 in a middle column, one fifth grid line 250 does not include the first sub-grid line 251 and the second sub-grid line 252, and such one fifth grid line 250 is defined as a third edge grid line. In this way, the third edge grid line can be electrically connected between two adjacent first grid lines 210, and thus being electrically connected to the first edge grid line 231, in combination with the fact that the plurality of first grid lines 210 in the same column are electrically connected through the same first intermediate grid line 232, the avoidance design between the second intermediate grid line 242 as a busbar and the fifth grid lines 250 as fingers with opposite polarity can be realized; meanwhile in the case where the avoidance design between the fifth grid line 250 and the second solder pads 320 with opposite polarity is realized, all first grid lines 210 and all fifth grid lines 250 can be electrically connected to the first edge grid line 231, so that the carriers collected by all first grid lines 210 and all fifth grid lines 250 can be collected by the first edge grid lines 231, and the current collecting efficiency of the back contact solar cell 10 can be improved.

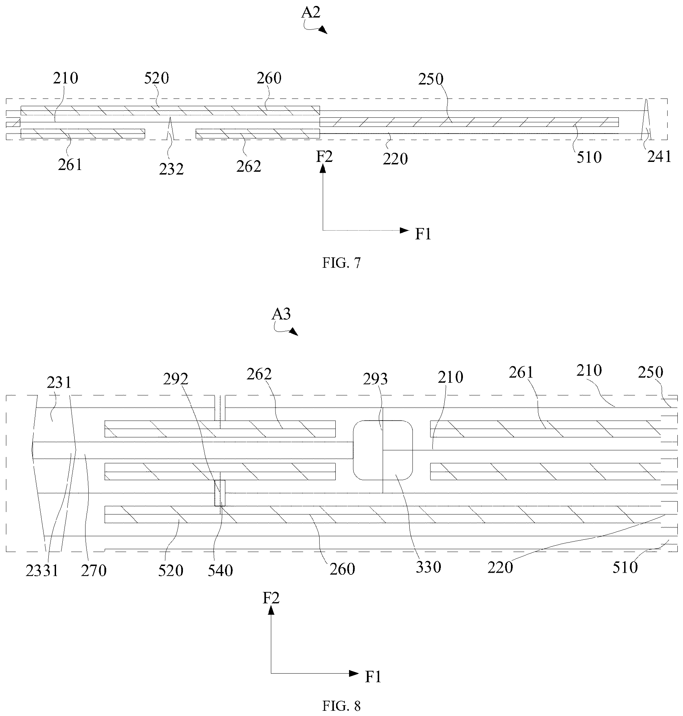

Referring to FIG. 1 and FIG. 7, some sixth grid lines 260 include a third sub-grid line 261 and a fourth sub-grid line 262 arranged at intervals along the first direction F1. Both the third sub-grid line 261 and the fourth sub-grid line 262 are electrically connected to the second grid lines 220. The first intermediate grid line 232 is located between the third sub-grid line 261 and the fourth sub-grid line 262 of the sixth grid line 260 adjacent to each other in the first direction F1 to be electrically isolated from such sixth grid line 260. The first solder pad 310 is located between the third sub-grid line 261 and the fourth sub-grid line 262 of the sixth grid line 260 adjacent to each other in the first direction F1 to be electrically isolated from such sixth grid line 260.

Specifically, the first intermediate grid line 232 is located between the third sub-grid lines 261 and the fourth sub-grid lines 262 of the sixth grid lines 260 in the same column in the first direction F1 to be electrically isolated from these sixth grid lines 260.

In this way, the first intermediate grid line 232 can be electrically isolated from the sixth grid lines 260 in the same column, and the first intermediate grid line 232 can be electrically connected to the first grid lines 210 in the same column, so that the carriers collected by the plurality of first grid lines 210 in the same column can be collected by the first intermediate grid line 232, an avoidance design between the first intermediate grid line 232 as a busbar and the sixth grid lines 260 as fingers with opposite polarity can be realized, and an avoidance design between the sixth grid lines 260 and the first solder pads 310 with opposite polarity can be realized.

It should be noted that at least one sixth grid line 260 in each column of sixth grid lines 260 does not include the third sub-grid line 261 and the fourth sub-grid line 262. For example, in the sixth grid lines 260 in a middle column, one sixth grid line 260 does not include the third sub-grid line 261 and the fourth sub-grid line 262, and such one sixth grid line 260 is defined as a fourth edge grid line. In this way, the fourth edge grid line can be electrically connected between two adjacent second grid lines 220, and thus being electrically connected to the second edge grid line 241, in combination with the fact that the plurality of second grid lines 220 in the same column are electrically connected through the same second intermediate grid line 242, the avoidance design between the first intermediate grid line 232 as the busbar and the sixth grid lines 260 as fingers with opposite polarity can be realized; meanwhile, in the case where the avoidance design between the sixth grid lines 260 and the first solder pads 310 with opposite polarity is realized, all second grid lines 220 and all sixth grid lines 260 can be electrically connected to the second edge grid line 241, so that the carriers collected by all second grid lines 220 and all sixth grid lines 260 can be collected by the second edge grid line 241, and the current collecting efficiency of the back contact solar cell 10 can be improved.

In some embodiments, referring to FIGS. 1, 6 and 7, the third edge grid line is located on a side of the solar cell substrate 100 along the second direction F2, the fourth edge grid line is located on another side of the solar cell substrate 100 along the second direction F2, and the third edge grid line and the fourth edge grid line are alternately arranged along the first direction F1.

Since the third edge grid line, which corresponds to the fifth grid line 250 that does not include the first sub-grid line 251 and the second sub-grid line 252, is located on a side of the solar cell substrate 100 along the second direction F2, the third edge grid line can be electrically connected to the first edge grid line 231 through the adjacent first grid line 210, while the second intermediate grid line 242 can be arranged on a side of the third edge grid line along the second direction F2. Thus, while an avoidance design between the second intermediate grid line 242 and the third edge grid line which have opposite polarities can be achieved, the second intermediate grid line 242 can be designed to be continuously arranged along the second direction F2, so that the second intermediate grid line 242 can be electrically connected to the second grid lines 220 in the same column, and the manufacturing convenience and the manufacturing efficiency of the back contact solar cell 10 can be improved.

Similarly, since the fourth edge grid line, which corresponds to the sixth grid line 260 that does not include the third sub-grid line 261 and the fourth sub-grid line 262, is located on another side of the solar cell substrate 100 along the second direction F2, the fourth edge grid line can be electrically connected to the second edge grid line 241 through the adjacent second grid line 220, while the first intermediate grid line 232 can be arranged on a side of the fourth edge grid line along the second direction F2. Thus, while an avoidance design between the s first intermediate grid line 232 and the fourth edge grid line which have opposite polarities can be achieved, the first intermediate grid line 232 can be designed to be continuously arranged along the second direction F2, so that the first intermediate grid line 232 can be electrically connected to the first grid lines 210 in the same column, and the manufacturing convenience and the manufacturing efficiency of the back contact solar cell 10 can be improved.

In some embodiments, referring to FIGS. 1, 8 and 9, the back contact solar cell 10 further includes a plurality of seventh grid lines 270 and a plurality of eighth grid lines 280, and the plurality of solder pads further include a plurality of third solder pads 330 and a plurality of fourth solder pads 340. The plurality of first solder pads 310 and the plurality of second solder pads 320 are located between the plurality of third solder pads 330 and the plurality of fourth solder pads 340 along the first direction F1. The plurality of third solder pads 330 and the first edge grid line 231 are spaced apart in the first direction F1 and disposed on a side of the solar cell substrate 100 along the first direction F1, and the third solder pads 330 are electrically connected to the first edge grid line 231 through the seventh grid lines 270. The plurality of fourth solder pads 340 and the second edge grid line 241 are spaced apart in the first direction F1 and disposed on another side of the solar cell substrate 100 along the first direction F1, and the fourth solder pads 340 are electrically connected to the second edge grid line 241 through the eighth grid lines 280.

Specifically, a first end portion 2331 of the first edge grid line 231 is electrically connected to an adjacent third solder pad 330 through a seventh grid line 270. In this way, the reliability of the connection between the first edge grid line 231 and the adjacent third solder pad 330 can be improved.

Specifically, a first end portion 2331 of the second edge grid line 241 is electrically connected to an adjacent fourth solder pad 340 through an eighth grid line 280. In this way, the reliability of the connection between the second edge grid line 241 and the adjacent fourth solder pad 340 can be improved.

The plurality of third solder pads 330 and the first edge grid line 231 are spaced apart along the first direction F1. In this way, the plurality of third solder pads 330 can be arranged in the same column, and are located on an inner side of the first edge grid line 231 in the first direction F1. That is, the plurality of third solder pads 330 are still a distance away from a side edge of the solar cell substrate 100 in the first direction F1, so that the reliability of the connection between the plurality of third solder pads 330 and the corresponding first solder strip electrically connected can be improved, and the reliability of the back contact solar cell 10 can be improved.

Similarly, the plurality of fourth solder pads 340 and the second edge grid line 241 are spaced apart along the first direction F1. In this way, the plurality of fourth solder pads 340 can be arranged in the same column, and are located on an inner side of the second edge grid line 241 in the first direction F1. That is, the plurality of fourth solder pads 340 are still a distance away from another side edge of the solar cell substrate 100 in the first direction F1, so that the reliability of the connection between the plurality of fourth solder pads 340 and the corresponding second solder strip electrically connected can be improved, and the reliability of the back contact solar cell 10 can be improved.

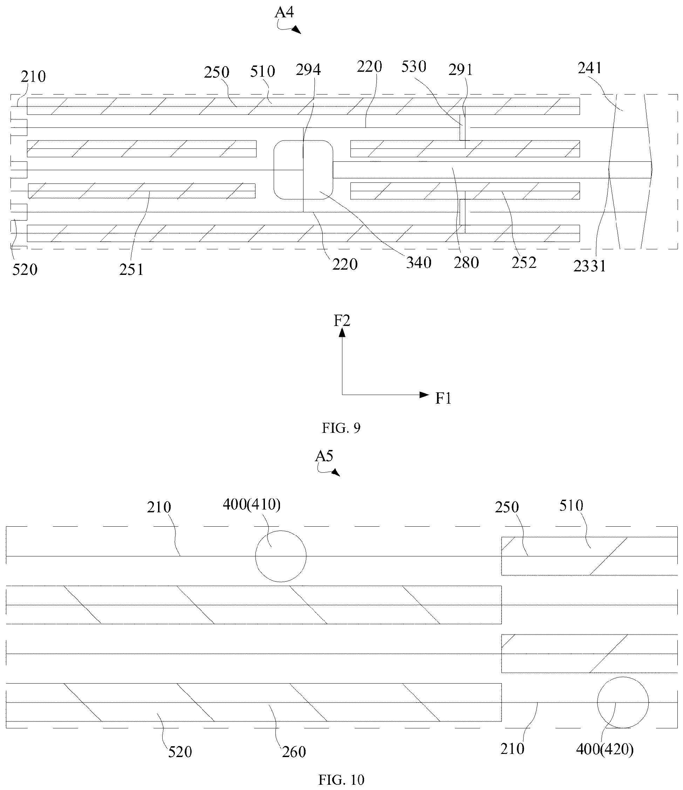

In some embodiments, as shown in FIG. 9, the back contact solar cell 10 further includes a ninth grid line 291. The plurality of fifth grid lines 250 are arranged in rows and columns. In the column of fifth grid lines 250 that is closest to the second edge grid line 241 in the first direction F1, a fifth grid line 250 that includes a first sub-grid line 251 and a second sub-grid line 252 is defined as a first target grid line. The first sub-grid line 251 of the first target grid line is electrically connected to the first grid line 210. The second sub-grid line 252 of the first target grid line is electrically connected to the first grid line 210 through an adjacent ninth grid line 291 and an adjacent fifth grid line 250. The fourth solder pad 340 is disposed between the first sub-grid line 251 and the second sub-grid line 252 of the first target grid line adjacent to each other in the first direction F1.

The fifth grid lines 250 in a column closest to the second edge grid line 241 in the first direction F1 are the fifth grid lines 250 located in an edge column, and the fifth grid lines 250 in other columns are the fifth grid lines 250 located in middle columns.

In this way, in a case where the fifth grid lines 250 in the same column are electrically isolated from the fourth solder pads 340 with opposite polarity, the fifth grid lines 250 in the column closest to the second edge grid line 241 in the first direction F1 can be electrically connected together.

As shown in FIG. 8, the back contact solar cell 10 further includes a plurality of eleventh grid lines 293 corresponding to the plurality of third solder pads 330. The eleventh grid line 293 and the third solder pad 330 intersect with each other and are connected to each other. The plurality of first grid lines 210 located in the same column as the third solder pad 330 include a plurality of first grid line groups corresponding to the plurality of third solder pads 330. Each first grid line group includes three first grid lines 210 arranged at intervals along the second direction F2. One first grid line 210 in the middle of each first grid line group is connected to the third solder pad 330. The other two first grid lines 210 in such first grid line group are located on two opposite sides of the corresponding third solder pad 330 in the second direction F2. The three first grid lines 210 of each first grid line group are electrically connected to the eleventh grid line 293.

In this way, the carriers collected by the three first grid lines 210 of the first grid line group can be collected to the eleventh grid line 293 and the corresponding third solder pad 330, and then collected to the first edge grid line 231.

It should be noted that the ninth grid line 291 extends along the second direction F2 and is connected between the second sub-grid line 252 of the first target grid line and the adjacent fifth grid line 250. A third insulating portion 530 covers a side of a corresponding ninth grid line 291 away from the solar cell substrate 100. The third insulating portion 530 is configured for electrically isolating the second grid line 220 on a side of the corresponding fourth solder pad 340 along the second direction F2 in a second grid line group from the adjacent ninth grid line 291.

In some embodiments, as shown in FIG. 8, the back contact solar cell 10 further includes a tenth grid line 292. The plurality of sixth grid lines 260 are arranged in rows and columns. In the column of sixth grid lines 260 that is closest to the first edge grid line 231 in the first direction F1, a sixth grid line 260 that includes a third sub-grid line 261 and a fourth sub-grid line 262 is defined as a second target grid line. The third sub-grid line 261 of the second target grid line is electrically connected to the second grid line 220. The fourth sub-grid line 262 of the second target grid line is electrically connected to the second grid line 220 through an adjacent tenth grid line 292 and an adjacent sixth grid line 260. The third solder pad 330 is disposed between the third sub-grid line 261 and the fourth sub-grid line 262 of the second target grid line adjacent to each other in the first direction F1.

The sixth grid lines 260 in a column closest to the first edge grid line 231 in the first direction F1 are the sixth grid lines 260 located in an edge column, and the sixth grid lines 260 in other columns are the sixth grid lines 260 located in middle columns.

In this way, in a case where the sixth grid lines 260 in the same column are electrically isolated from the third solder pads 330 with opposite polarity, the sixth grid lines 260 in the column closest to the first edge grid line 231 in the first direction F1 can be electrically connected together.

As shown in FIG. 9, the back contact solar cell 10 further includes a plurality of twelfth grid lines 294 corresponding to the plurality of fourth solder pads 340. The twelfth grid line 294 and the fourth solder pad 340 intersect with each other and are connected to each other. The plurality of second grid lines 220 located in the same column as the fourth solder pad 340 include a plurality of second grid line groups corresponding to the plurality of fourth solder pads 340. Each second grid line group includes three second grid lines 220 arranged at intervals along the second direction F2. One second grid line 220 in the middle of each second grid line group is connected to the fourth solder pad 340. The other two second grid lines 220 in such second grid line group are located on two opposite sides of the corresponding fourth solder pad 340 in the second direction F2. The three second grid lines 220 of each second grid line group are electrically connected to the twelfth grid line 294.

In this way, the carriers collected by the three second grid lines 220 of the second grid line group can be collected to the twelfth grid line 294 and the corresponding fourth solder pad 340, and then collected to the second edge grid line 241.

It should be noted that the tenth grid line 292 extends along the second direction F2 and is connected between the fourth sub-grid line 262 of the second target grid line and the adjacent sixth grid line 260. A fourth insulating portion 540 covers a side of the corresponding tenth grid line 292 away from the solar cell substrate 100. The fourth insulating portion 540 is configured for electrically isolating the first grid line 210 on a side of the corresponding fourth solder pad 340 along the second direction F2 in a first grid line group from the adjacent tenth grid line 292.

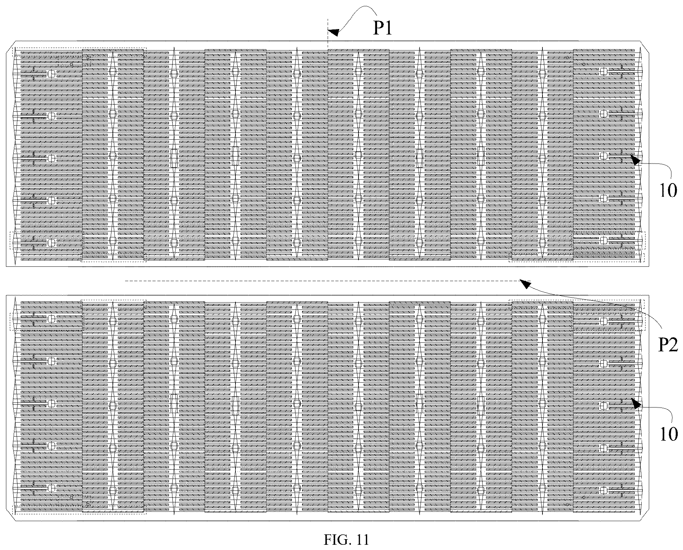

In some embodiments, referring to FIGS. 1, 10 and 11, the back contact solar cell 10 further includes at least two positioning marks 400 disposed on the solar cell substrate 100. The plurality of first grid lines 210 and the plurality of second grid lines 220 are arranged on the solar cell substrate 100 at preset positions with reference to the at least two positioning marks 400. The at least two positioning marks 400 are symmetrically distributed relative to a first preset plane P1. A spacing between centers of two adjacent positioning marks 400 in the first direction F1 is a first preset spacing. In two back contact solar cells 10 symmetrically arranged relative to a second preset plane P2, a spacing between centers of two adjacent positioning marks 400 in the second direction F2 is a second preset spacing. The first preset plane P1 is perpendicular to the first direction F1. The second preset plane P2 is perpendicular to the second direction F2. The first direction F1 and the second direction F2 intersect with each other, and both are perpendicular to the thickness direction of the solar cell substrate 100.

Optionally, the first preset spacing is in a range from 110 mm to 130 mm. For example, the first preset spacing is 110 mm, 120 mm, or 130 mm.

Optionally, the second preset spacing is 110 mm, 120 mm, or 130 mm.

The at least two positioning marks 400 can be designed according to the dimension of the solar cell substrate 100 in the plane where the solar cell substrate 100 is located and the arrangement requirements of the plurality of first grid lines 210 and the plurality of second grid lines 220, so that the plurality of first grid lines 210 and the plurality of second grid lines 220 are arranged on the solar cell substrate 100 at preset positions with reference to the at least two positioning marks 400, thereby improving the positional accuracy of the plurality of first grid lines 210 and the plurality of second grid lines 220 on the solar cell substrate 100.

In some embodiments, the at least two positioning marks 400 include at least two first positioning marks 410 and at least two second positioning marks 420. The preset positions include first preset positions corresponding to the plurality of first grid lines 210, and second preset positions corresponding to the plurality of second grid lines 220. The plurality of first grid lines 210 are arranged on the solar cell substrate 100 at the first preset positions with reference to the at least two first positioning marks 410. The plurality of second grid lines 220 are arranged on the solar cell substrate 100 at the second preset positions with reference to the at least two second positioning marks 420.

The positional accuracy of the plurality of first grid lines 210 on the solar cell substrate 100 can be improved by using the at least two first positioning marks 410, and the positional accuracy of the plurality of second grid lines 220 on the solar cell substrate 100 can be improved by using the at least two second positioning marks 420.

In some embodiments, the orthographic projection of the positioning mark 400 on the solar cell substrate 100 is configured as a circle having a diameter in a range from 0.01 mm to 2 mm.

Exemplarily, the diameter of the circle is 0.01 mm, 0.5 mm, 1 mm or 2 mm.

Setting the diameter of the circle within a suitable range not only facilitates positioning with reference to the center of the positioning mark 400, but also does not affect the layout of the grid lines such as the first grid lines 210 and the second grid lines 220.

In some embodiments, the plurality of first grid lines 210 are arranged in rows and columns. The first grid line 210 has the first symmetry axis parallel to the first direction F1. The orthographic projection of the center of the first positioning mark 410 on the solar cell substrate 100 coincides with the orthographic projection of the first symmetry axis of the first grid lines 210 in the corresponding row on the solar cell substrate 100.

In this way, the first grid line 210 can be symmetrically arranged with respect to the first positioning mark 410, thereby facilitating to improve the positional accuracy of the plurality of first grid lines 210 on the solar cell substrate 100.

In some embodiments, the plurality of second grid lines 220 are arranged in rows and columns. The second grid line 220 has the second symmetry axis parallel to the first direction F1. The orthographic projection of the center of the second positioning mark 420 on the solar cell substrate 100 coincides with the orthographic projection of the second symmetry axis of the second grid lines 220 in the corresponding row on the solar cell substrate 100.

In this way, the second grid line 220 can be symmetrically arranged with respect to the second positioning mark 420, thereby facilitating to improve the positional accuracy of the plurality of second grid lines 220 on the solar cell substrate 100.

In some embodiments, the back contact solar cell 10 further includes an insulating layer. The insulating layer includes first insulating portions 510 in one-to-one correspondence with the plurality of fifth grid lines 250, second insulating portions 520 in one-to-one correspondence with the plurality of sixth grid lines 260, third insulating portions 530, and fourth insulating portions 540. The first insulating portion 510 covers a side of a corresponding fifth grid line 250 away from the solar cell substrate 100. The second insulating portion 520 covers a side of a corresponding sixth grid line 260 away from the solar cell substrate 100. The third insulating portion 530 covers a side of a corresponding ninth grid line 291 away from the solar cell substrate 100. The fourth insulating portion 540 covers a side of a corresponding tenth grid line 292 away from the solar cell substrate 100.

Specifically, the third insulating portion 530 is connected between two adjacent first insulating portions 510 in the second direction F2, and the fourth insulating portion 540 is connected between two adjacent second insulating portions 520 in the second direction F2.

In the process of welding a corresponding first solder strip on the first solder pads 310 or in the process of welding a corresponding first solder strip on the third solder pads 330, the second insulating portion 520 can be used to electrically isolate the sixth grid lines 260 in the same column with the first solder pads 310 or the third solder pads 330 from a solder strip with opposite polarity (i.e., the first solder strip), so as to avoid the short circuit problem caused by the electrical connection between the sixth grid lines 260 and the solder strip with opposite polarity.

Similarly, in the process of welding a corresponding second solder strip on the second solder pads 320 or in the process of welding a corresponding second solder strip on the fourth solder pads 340, the first insulating portion 510 can be used to electrically isolate the fifth grid lines 250 in the same column with the second solder pads 320 or the fourth solder pads 340 from a solder strip with opposite polarity (i.e., the second solder strip), so as to avoid the short circuit problem caused by the electrical connection between the fifth grid lines 250 and the solder strip with opposite polarity.

Similarly, in the process of welding a corresponding first solder strip on the third solder pads 330, the fourth insulating portion 540 can be used to electrically isolate the tenth grid lines 292 in the same column with the third solder pads 330 from a solder strip with opposite polarity (i.e., the first solder strip), so as to avoid the short circuit problem caused by the electrical connection between the tenth grid lines 292 and the solder strip with opposite polarity.

Similarly, in the process of welding a corresponding second solder strip on the fourth solder pads 340, the third insulating portion 530 can be used to electrically isolate the ninth grid lines 291 in the same column with the fourth solder pads 340 from a solder strip with opposite polarity (i.e., the second solder strip), so as to avoid the short circuit problem caused by the electrical connection between the ninth grid lines 291 and the solder strip with opposite polarity.

An embodiment of the present application provides a photovoltaic module, including a solar cell string. The solar cell string includes a plurality of back contact solar cells 10 according to any of the above embodiments.

It should be noted that the back contact solar cell 10 described above is a half-cell sheet, and a plurality of back contact solar cells 10 are connected in series by a plurality of first solder strips and a plurality of second solder strips to form a solar cell string.

All the first solder strips are respectively disposed corresponding to all the first solder pads 310 and all the third solder pads 330. A plurality of first solder pads 310 in the same column are all electrically connected to a corresponding first solder strip. A plurality of third solder pads 330 in the same column are all electrically connected to another corresponding first solder strip. All the second solder strips are respectively disposed corresponding to all the second solder pads 320 and all the fourth solder pads 340. A plurality of second solder pads 320 in the same column are all electrically connected to a corresponding second solder strip. A plurality of fourth solder pads 340 in the same column are all electrically connected to another corresponding second solder strip.

In this way, for two adjacent back contact solar cells 10, the plurality of first solder strips of one back contact solar cell 10 can be connected to the plurality of second solder strips of the other back contact solar cell 10 through a bus bar. In this way, the plurality of back contact solar cells 10 can be connected in series to form the solar cell string.

The technical features of the embodiments above may be combined arbitrarily. To make the description concise, not all possible combinations of the technical features in the above embodiments are described. However, as long as there are no contradictions in the combinations of these technical features, all of the combinations should be considered to be within the scope of the specification.

The embodiments above only represent several implementation modes of the present application, and the description thereof is relatively specific and detailed, but it should not be construed as limiting the scope of the patent. It should be noted that for those skilled in the art, various modifications and improvements may be made without departing from the concept of the present application, and all these modifications and improvements belong to the protection scope of the present application. Therefore, the scope of protection of the patent application should be subject to the appended claims.

## Claims

1. A back contact solar cell (10), comprising:
a solar cell substrate (100) having a front surface and a back surface disposed opposite to each other in a thickness direction perpendicular to the solar cell substrate (100);
a plurality of first grid lines (210) and a plurality of second grid lines (220) disposed on the back surface, wherein the first grid lines (210) and the second grid lines (220) are alternately arranged; and
a plurality of solder pads disposed on the back surface, and comprising a plurality of first solder pads (310) and a plurality of second solder pads (320); wherein the plurality of first solder pads (310) are electrically connected to the plurality of first grid lines (210), and the plurality of second solder pads (320) are electrically connected to the plurality of second grid lines (220);
wherein the plurality of first solder pads (310) comprises a first test solder pad (311), and the first test solder pad (311) is electrically connected to at least two adjacent first grid lines (210); and
the plurality of second solder pads (320) comprises a second test solder pad (321), and the second test solder pad (321) is electrically connected to at least two adjacent second grid lines (220).

2. The back contact solar cell (10) according to claim 1, wherein the plurality of solder pads are arranged in rows and columns; the plurality of solder pads are arranged in n columns, and the first test solder pad (311) is located in at least one column from column 2 to column n-1; the second test solder pad (321) is located in at least one column from column 2 to column n-1, and the second test solder pad (321) is located in a different column from the first test solder pad (311); where n is a positive integer, where 10≤n≤20;
the plurality of solder pads are arranged in rows along a first direction, and in columns along a second direction; the plurality of solder pads are arranged in m rows; the solar cell substrate (100) has a straight edge (103) and a chamfer edge (104) disposed opposite to each other along the second direction; along a direction from the chamfer edge (104) toward the straight edge (103), the first test solder pad (311) is located in one row from row 2 to row m, and the second test solder pad (321) is located in one row from row 2 to row m; where m is a positive integer, where 2≤m≤6;
the plurality of first solder pads (310) further comprise a plurality of first connection solder pads; and an orthographic projection area of the first test solder pad (311) on the solar cell substrate (100) is larger than an orthographic projection area of the first connection solder pad on the solar cell substrate (100);
the plurality of second solder pads (320) further comprise a plurality of second connection solder pads (322); and an orthographic projection area of the second test solder pad (321) on the solar cell substrate (100) is larger than an orthographic projection area of the second connection solder pad (322) on the solar cell substrate (100); and
wherein the first direction and the second direction intersect with each other, and both are perpendicular to the thickness direction of the solar cell substrate (100).

3. The back contact solar cell (10) according to claim 1 or 2, wherein the plurality of first grid lines (210) and the plurality of second grid lines (220) are disposed extending along the first direction; the plurality of first solder pads (310) further comprise a plurality of first connection solder pads; a dimension of the first test solder pad (311) in the second direction is larger than a dimension of the first connection solder pad in the second direction; the plurality of second solder pads (320) further comprise a plurality of second connection solder pads (322); a dimension of the second test solder pad (321) in the second direction is larger than a dimension of the second connection solder pad (322) in the second direction; and wherein the first direction and the second direction intersect with each other, and both are perpendicular to the thickness direction of the solar cell substrate (100);
the dimension of the first test solder pad (311) in the second direction is in a range from 2 mm to 4 mm, and the dimension of the first test solder pad (311) in the first direction is in a range from 0.2 mm to 3 mm;
the dimension of the second test solder pad (321) in the second direction is in a range from 2 mm to 4 mm, and the dimension of the second test solder pad (321) in the first direction is in a range from 0.2 mm to 3 mm;
the plurality of first solder pads (310) comprise a plurality of first connection solder pads; and a dimension of the first connection solder pad in the second direction is in a range from 0.3 mm to 3 mm, and a dimension of the first connection solder pad in the first direction is in a range from 0.2 mm to 3 mm; and
the plurality of second solder pads (320) comprise a plurality of second connection solder pads (322); and a dimension of the second connection solder pad (322) in the second direction is in a range from 0.3 mm to 3 mm, and a dimension of the second connection solder pad (322) in the first direction is in a range from 0.2 mm to 3 mm.

4. The back contact solar cell (10) according to any one of claims 1 to 3, wherein the back contact solar cell (10) further comprises a plurality of third grid lines (230) and a plurality of fourth grid lines (240); the plurality of third grid lines (230) and the plurality of fourth grid lines (240) are alternately arranged on the back surface of the solar cell substrate (100) along the first direction F1, and both are disposed extending along the second direction; the plurality of first grid lines (210) and the plurality of second grid lines (220) are disposed extending along the first direction; the plurality of third grid lines (230) are electrically connected to the plurality of first grid lines (210); the plurality of fourth grid lines (240) are electrically connected to the plurality of second grid lines (220); and wherein the first direction and the second direction intersect with each other, and both are perpendicular to the thickness direction of the solar cell substrate (100).

5. The back contact solar cell (10) according to claim 4, wherein each of the plurality of third grid lines (230) and the plurality of fourth grid lines (240) comprises a plurality of first portions (233) connected in the second direction;
each first portion (233) has a first end portion (2331) and a second end portion (2332) disposed opposite to each other in the second direction;
a dimension of the first end portion (2331) in the first direction is different from a dimension of the second end portion (2332) in the first direction; and
two adjacent first end portions (2331) of two adjacent first portions (233) are connected; or two adjacent second end portions (2332) of two adjacent first portions (233) are connected.

6. The back contact solar cell (10) according to claim 5, wherein the dimension of the first end portion (2331) in the first direction is larger than the dimension of the second end portion (2332) in the first direction;
an orthographic projection of the first end portion (2331) on a target plane overlaps with an orthographic projection of a corresponding solder pad on the target plane; an orthographic projection of the second end portion (2332) on the target plane is offset from an orthographic projection of the corresponding solder pad on the target plane; and the target plane is perpendicular to the thickness direction of the solar cell substrate (100); and
the dimension of the first end portion (2331) in the first direction is in a range from 0.2 mm to 1.8 mm, and the dimension of the second end portion (2332) in the first direction is in a range from 0.02 mm to 1.6 mm.

7. The back contact solar cell (10) according to any one of claims 4 to 6, wherein the plurality of third grid lines (230) comprises a first edge grid line (231) and a plurality of first intermediate grid lines (232) electrically connected to the first edge grid line (231), the plurality of fourth grid lines (240) comprises a second edge grid line (241) and a plurality of second intermediate grid lines (242) electrically connected to the second edge grid line (241), and the plurality of first intermediate grid lines (232) and the plurality of second intermediate grid lines (242) are alternately arranged along the first direction and are located between the first edge grid line (231) and the second edge grid line (241);
the plurality of first grid lines (210) adjacent to each other in the second direction are electrically connected to the same first intermediate grid line (232); and
the plurality of second grid lines (220) adjacent to each other in the second direction are electrically connected to the same second intermediate grid line (242).

8. The back contact solar cell (10) according to claim 7, wherein the back contact solar cell (10) further comprises a plurality of fifth grid lines (250) and a plurality of sixth grid lines (260) extending in the first direction, and the plurality of fifth grid lines (250) and the plurality of sixth grid lines (260) are alternately arranged;
the plurality of first grid lines (210) and the plurality of fifth grid lines (250) are alternately arranged along the first direction and both are electrically connected to the first edge grid line (231); and the plurality of first grid lines (210) and the plurality of sixth grid lines (260) are alternately arranged along the second direction;
the plurality of second grid lines (220) and the plurality of sixth grid lines (260) are alternately arranged along the first direction and both are electrically connected to the second edge grid line (241); and the plurality of second grid lines (220) and the plurality of fifth grid lines (250) are alternately arranged along the second direction.

9. The back contact solar cell (10) according to claim 8, wherein a part of the plurality of fifth grid lines (250) each comprises a first sub-grid line (251) and a second sub-grid line (252) arranged at intervals along the first direction; both the first sub-grid line (251) and the second sub-grid line (252) are electrically connected to the first grid lines (210); the second intermediate grid line (242) is located between the first sub-grid line (251) and the second sub-grid line (252) of the fifth grid line (250) adjacent to each other in the first direction to be electrically isolated from such fifth grid line (250); and the second solder pad (320) is located between the first sub-grid line (251) and the second sub-grid line (252) of the fifth grid line (250) adjacent to each other in the first direction to be electrically isolated from such fifth grid line (250); and
a part of the plurality of sixth grid lines (260) each comprises a third sub-grid line (261) and a fourth sub-grid line (262) arranged at intervals along the first direction; both the third sub-grid line (261) and the fourth sub-grid line (262) are electrically connected to the second grid lines (220); the first intermediate grid line (232) is located between the third sub-grid line (261) and the fourth sub-grid line (262) of the sixth grid line (260) adjacent to each other in the first direction to be electrically isolated from such sixth grid line (260); and the first solder pad (310) is located between the third sub-grid line (261) and the fourth sub-grid line (262) of the sixth grid line (260) adjacent to each other in the first direction to be electrically isolated from such sixth grid line (260).

10. The back contact solar cell (10) according to claim 9, wherein the back contact solar cell (10) further comprises a plurality of seventh grid lines (270) and a plurality of eighth grid lines (280); the plurality of solder pads further comprise a plurality of third solder pads (330) and a plurality of fourth solder pads (340); the plurality of first solder pads (310) and the plurality of second solder pads (320) are located between the plurality of third solder pads (330) and the plurality of fourth solder pads (340) along the first direction; the plurality of third solder pads (330) and the first edge grid line (231) are spaced apart in the first direction and disposed on a side of the solar cell substrate (100) along the first direction, and the plurality of third solder pads (330) are electrically connected to the first edge grid line (231) through the seventh grid lines (270); and the plurality of fourth solder pads (340) and the second edge grid line (241) are spaced apart in the first direction and disposed on another side of the solar cell substrate (100) along the first direction, and the plurality of fourth solder pads (340) are electrically connected to the second edge grid line (241) through the eighth grid lines (280).

11. The back contact solar cell (10) according to claim 10, wherein the back contact solar cell (10) further comprises a plurality of ninth grid lines (291); the plurality of fifth grid lines (250) are arranged in rows and columns, in a column of fifth grid lines (250) that is closest to the second edge grid line (241) in the first direction, a fifth grid line (250) comprising the first sub-grid line (251) and the second sub-grid line (252) is defined as a first target grid line, the first sub-grid line (251) of the first target grid line is electrically connected to the first grid line (210), the second sub-grid line (252) of the first target grid line is electrically connected to the first grid line (210) through an adjacent ninth grid line (291) and an adjacent fifth grid line (250); and the fourth solder pad (340) is disposed between the first sub-grid line (251) and the second sub-grid line (252) of the first target grid line adjacent to each other in the first direction.

12. The back contact solar cell (10) according to claim 10 or 11, wherein the back contact solar cell (10) further comprises a plurality of tenth grid lines (292); the plurality of sixth grid lines (260) are arranged in rows and columns, in a column of sixth grid lines (260) that is closest to the first edge grid line (231) in the first direction, a sixth grid line (260) comprising the third sub-grid line (261) and the fourth sub-grid line (262) is defined as a second target grid line; the third sub-grid line (261) of the second target grid line is electrically connected to the second grid line (220), the fourth sub-grid line (262) of the second target grid line is electrically connected to the second grid line (220) through an adjacent tenth grid line (292) and an adjacent sixth grid line (260); and the third solder pad (330) is disposed between the third sub-grid line (261) and the fourth sub-grid line (262) of the second target grid line adjacent to each other in the first direction.

13. The back contact solar cell (10) according to any one of claims 1 to 12, wherein the back contact solar cell (10) further comprises at least two positioning marks (400) disposed on the solar cell substrate (100);
the plurality of first grid lines (210) and the plurality of second grid lines (220) are arranged on the solar cell substrate (100) at preset positions with reference to the at least two positioning marks (400);
the at least two positioning marks (400) are symmetrically distributed relative to a first preset plane (P1);
a spacing between centers of two adjacent positioning marks (400) in the first direction is a first preset spacing;
in two back contact solar cells (10) symmetrically arranged relative to a second preset plane (P2), a spacing between centers of two adjacent positioning marks (400) in the second direction is a second preset spacing;
the first preset plane (P1) is perpendicular to the first direction, the second preset plane (P2) is perpendicular to the second direction, and the first direction and the second direction intersect with each other and both are perpendicular to the thickness direction of the solar cell substrate (100);
the first preset spacing is in a range from 110 mm to 130 mm; and
the second preset spacing is in a range from 110 mm to 130 mm.

14. The back contact solar cell (10) according to claim 13, wherein the at least two positioning marks (400) comprise at least two first positioning marks (410) and at least two second positioning marks (420);
the preset positions comprise a plurality of first preset positions corresponding to the plurality of first grid lines (210), and a plurality of second preset positions corresponding to the plurality of second grid lines (220); the plurality of first grid lines (210) are arranged on the solar cell substrate (100) at the first preset positions with reference to the at least two first positioning marks **(410);** and the plurality of second grid lines (220) are arranged on the solar cell substrate (100) at the second preset positions with reference to the at least two second positioning marks (420);
an orthographic projection of the positioning mark on the solar cell substrate (100) is configured as a circle having a diameter in a range from 0.01 mm to 2 mm;
the plurality of first grid lines (210) are arranged in rows and columns; each of the plurality of first grid lines (210) has a first symmetry axis parallel to the first direction; and an orthographic projection of a center of the first positioning mark **(410)** on the solar cell substrate (100) coincides with an orthographic projection of the first symmetry axis of the first grid line (210) in a corresponding row on the solar cell substrate (100); and
the plurality of second grid lines (220) are arranged in rows and columns; each of the plurality of second grid lines (220) has a second symmetry axis parallel to the first direction; and an orthographic projection of a center of the second positioning mark (420) on the solar cell substrate (100) coincides with an orthographic projection of the second symmetry axis of the second grid line (220) in a corresponding row on the solar cell substrate (100).

15. A photovoltaic module, comprising a solar cell string, wherein the solar cell string comprises a plurality of back contact solar cells (10) according to any one of claims 1 to 14.
